# EUROPEAN PATENT APPLICATION

(11) **EP 4 418 306 A1**
(43) Date of publication of application: **21.08.2024**
(21) Application number: 22880723.6
(22) Date of filing: 20.09.2022
(51) Int. Cl.: H01L 21/304

(54) **POLISHING COMPOSITION**

(30) Priority: 12.10.2021 JP 2021167127
(71) Applicant: Fujimi Incorporated, Kiyosu-shi, Aichi 452-8502 (JP)
(72) Inventor: GOTO, Osamu, Kiyosu-shi, Aichi 452-8502 (JP); TAKAMA, Daiki, Kiyosu-shi, Aichi 452-8502 (JP); TANAKA, Yuki, Kiyosu-shi, Aichi 452-8502 (JP)
(74) Representative: Grünecker Patent- und Rechtsanwälte PartG mbB
(86) International application number: PCT/JP2022/034908
(87) International publication number: WO 2023/063027

(57) **Abstract**

A novel composition suitable for polishing is provided. Provided is a polishing composition containing silica particles as an abrasive, a basic compound, and water. The polishing composition further contains an inorganic-acid ammonium salt.

## Description

### [Technical Field]

The present invention relates to a polishing composition.

The application claims the priority based on Japanese Patent Application No. 2021-167127, filed on October 12, 2021, the content of which is herein incorporated by reference in its entirety.

### [Background Art]

A surface of a material such as metal, semimetal, non-metal, or an oxide thereof has been finely polished with a polishing composition. For example, a surface of a silicon wafer used as a component of a semiconductor device or the like is generally finished into a high-grade mirror plane via a lapping step (rough polishing step) and a polishing step (fine polishing step). The polishing step typically includes a stock polishing step and a final polishing step (last polishing step). Patent Document 1 is an exemplary technical reference of a polishing composition mainly used in application of polishing a semiconductor substrate such as a silicon wafer.

### [Citation List]

### [Patent Literature]

[Patent Document 1] Japanese Patent No. 6050125

### [Summary of Invention]

### [Technical Problem]

A polishing composition for use has a polishing capability to efficiently polish an object to be polished. For example, polishing of a semiconductor substrate, such as a silicon wafer as described above, or other substrates can be leveraged by mechanical polishing action by abrasives and chemical polishing action by a basic compound (alkali etching), which provide higher removal ability. A polishing composition with high removal ability is preferred because it enables improvement in production efficiency, cost effectiveness, etc.

In addition, a polishing composition used in polishing of the substrate, such as a polishing composition used in a final polishing step (particularly, a final polishing step of a semiconductor substrate such as a silicon wafer, or other substrates), may also be required to have performance to provide a high-quality surface after polishing. Improvement in a surface quality of a polishing surface is provided by, e.g., a method of protecting a substrate by an additive, such as a water-soluble polymer or a surfactant, that is contained in a polishing composition. For example, Patent Document 1 discloses a polishing composition containing colloidal silica, ammonia, and a water-soluble polymer (hydroxyethyl cellulose). However, the water-soluble polymer and the other components are for protecting a surface of a substrate to be polished, and use of such additives can cause reduced removal ability, and in turn, reduced production efficiency. In general, there is a trade-off relationship between an improved quality of a polishing surface and a polishing removal rate, and the polishing is required to achieve good balance between an improved surface quality and a polishing removal rate.

As has been described thus far, in polishing of a variety of substrates, there has been demand for a polishing composition that can enhance a polishing removal rate regardless of presence or absence of a water-soluble polymer, a surfactant, etc. Moreover, it is practically beneficial to provide a polishing composition that can enhance a polishing removal rate along with maintaining a quality of a polishing surface; as is particularly true in a final polishing step, for example.

The present invention was created under the circumstance described above, and has an objective to provide a novel composition suitable for polishing.

### [Solution to Problem]

The specification provides a polishing composition containing silica particles as an abrasive, a basic compound, and water. The polishing composition further contains an inorganic-acid ammonium salt. Use of an inorganic-acid ammonium salt in composition containing silica particles and a basic compound allows enhancing a polishing removal rate. That is, a composition suitable for polishing is provided.

In some preferred embodiments, the inorganic-acid ammonium salt contains divalent or more polyvalent inorganic acid. An ammonium salt of inorganic acid having a valency of two or more is likely to provide a better polishing removal rate.

In some preferred embodiments, the inorganic-acid ammonium salt contains a phosphoric acid ammonium salt. Use of a phosphoric acid ammonium salt as the inorganic-acid ammonium salt allows providing a better polishing removal rate.

In some embodiments, the polishing composition further contains at least one kind of water-soluble polymer. Inclusion of a water-soluble polymer in the polishing composition enables improvement in a polished surface quality (e.g., haze). With composition containing a water-soluble polymer, the polishing composition disclosed herein also allows enhancing a polishing removal rate along with maintaining a quality of a polishing surface. In other words, the inorganic-acid ammonium salt in the polishing composition can contribute to enhancement in a polishing removal rate without impairing an effect of use of a water-soluble polymer (an effect to improve a quality of a polishing surface).

In some embodiments, the polishing composition contains two or more kinds of water-soluble polymers. Selection and use of plural kinds of water-soluble polymers allows providing a good effect to improve haze. With composition containing two or more kinds of water-soluble polymers, the polishing composition disclosed herein also enables combination of maintenance of a surface quality and enhancement in a polishing removal rate.

In some embodiments, the polishing composition contains a polyvinyl alcohol-based polymer as a water-soluble polymer. With a polyvinyl alcohol-based polymer, the polishing composition is likely to provide a high-quality polishing surface. For example, combination use of a polyvinyl alcohol-based polymer and another water-soluble polymer as water-soluble polymers enables effective improvement in haze.

In some embodiments, the polishing composition contains a nitrogen atom-containing polymer as a water-soluble polymer. With a nitrogen atom-containing polymer, the polishing composition is likely to provide a high-quality polishing surface. For example, combination use of a nitrogen atom-containing polymer and another water-soluble polymer as water-soluble polymers enables effective improvement in haze.

In some embodiments, the polishing composition further contains at least one kind of surfactant. Inclusion of a surfactant in the polishing composition enables reduction in haze. With composition containing a surfactant, the polishing composition disclosed herein also allows enhancing a polishing removal rate along with maintaining a quality (particularly, haze) of a polishing surface. In other words, the inorganic-acid ammonium salt in the polishing composition can contribute to enhancement in a polishing removal rate without impairing action from a surfactant.

In some embodiments, the polishing composition contains two or more kinds of nonionic surfactants as surfactants. Selection and use of two or more kinds of nonionic surfactants as surfactants may lead to more exertion of an effect to reduce haze.

The polishing composition disclosed herein may be preferably used for polishing a silicon wafer. Polishing a silicon wafer with use of the polishing composition allows efficient production of a silicon wafer surface with high quality.

### [Description of Embodiments]

Preferred embodiments of the present invention will be described below. Matters that are other than those particularly mentioned herein but are necessary for implementation of the present invention can be recognized as matters to be designed by those skilled in the art based on conventional technologies in the art. The present invention can be implemented based on contents disclosed herein and common technical knowledge in the art.

### <Abrasive>

The polishing composition disclosed herein contains silica particles as an abrasive. Silica particles as an abrasive function to mechanically polish a surface of an object to be polished. Inclusion of an abrasive in the polishing composition allows enhancing a polishing removal rate based on mechanical polishing action from presence of an abrasive. When the polishing composition can be used in polishing (e.g., final polishing) of an object to be polished having a surface formed of silicon, such as a silicon wafer as described later, it is particularly significant to employ silica particles as an abrasive.

Specific examples of the silica particles include colloidal silica, fumed silica, and precipitated silica. Silica particles can be used singly or in combination of two or more kinds thereof. Colloidal silica is particularly preferably used because it facilitates production of a polishing surface with an excellent surface grade after polishing. Examples of colloidal silica to be potentially preferably employed include colloidal silica prepared from water glass (sodium silicate) as a raw material by ion-exchanging, and colloidal silica prepared from alkoxide (colloidal silica produced by a hydrolysis-condensation reaction of alkoxysilane). Colloidal silica can be used singly or in combination of two or more kinds thereof.

The absolute specific gravity of silica that forms the silica particles is preferably 1.5 or more, more preferably 1.6 or more, and even more preferably 1.7 or more. The upper limit of the absolute specific gravity of silica is not particularly limited, but is typically 2.3 or less, and e.g., 2.2 or less. As the absolute specific gravity of the silica particles, a measured value derived by liquid replacement using ethanol as a replacing liquid can be employed.

The average primary particle diameter of the abrasive (typically, silica particles) is not particularly limited, but in view of a polishing removal rate, etc., it is preferably 5 nm or more, and more preferably 10 nm or more. In view of providing a higher effect of polishing (an effect such as reduction in haze or removal of a defect), the average primary particle diameter is preferably 15 nm or more, and more preferably 20 nm or more (e.g., more than 20 nm). In view of preventing a scratch, etc., the average primary particle diameter of the abrasive is preferably 100 nm or less, more preferably 50 nm or less, and even more preferably 45 nm or less. In view of producing a lower-haze surface with ease, the average primary particle diameter of the abrasive in some embodiments may be 43 nm or less, less than 40 nm, less than 38 nm, less than 35 nm, less than 32 nm, or less than 30 nm.

An average primary particle diameter, as used herein, refers to a particle diameter (BET particle diameter) calculated from a specific surface area measured by a BET method (BET value) by the formula: average primary particle diameter (nm) = 6000/(true density (g/cm³) × BET value (m²/g)). The specific surface area can be measured using e.g., a surface area measurement device with the product name of "Flow Sorb II 2300", manufactured by Micromeritics Instrument Corporation.

The average secondary particle diameter of the abrasive (typically, silica particles) is not particularly limited, and can be appropriately selected from, e.g., the range of about 15 nm to 300 nm. In view of improving a polishing removal rate, the average secondary particle diameter is preferably 30 nm or more, and more preferably 35 nm or more. In some embodiments, the average secondary particle diameter may be, e.g., 40 nm or more, 42 nm or more, or preferably 44 nm or more. The average secondary particle diameter is usually, advantageously 250 nm or less, preferably 200 nm or less, and more preferably 150 nm or less. In some preferred embodiments, the average secondary particle diameter is 120 nm or less, more preferably 100 nm or less, and even more preferably 70 nm or less, and may be e.g., 60 nm or less or 50 nm or less.

An average secondary particle diameter, as used herein, refers to a particle diameter (volume average particle diameter) measured by dynamic light scattering. The average secondary particle diameter of the abrasive can be measured by dynamic light scattering using e.g., the product named "NANOTRAC UPA-UT151" manufactured by Nikkiso Co., Ltd.

The shape (outer shape) of the silica particles may be globular or non-globular. Specific examples of the particles having non-globular forms include peanut-shaped (i.e., peanut shell-shaped) particles, cocoon-shaped particles, conpeito-shaped particles, and rugby ball-shaped particles. For example, an abrasive majorly including peanut-shaped or cocoon-shaped particles may be preferably employed.

Without particular limitation, the average value of major axis/minor axis ratios (average aspect ratio) of the silica particles is theoretically 1.0 or more, preferably 1.05 or more, and even more preferably 1.1 or more. Increase in the average aspect ratio can achieve a higher polishing removal rate. In view of reducing scratches, etc., the average aspect ratio of the abrasive is preferably 3.0 or less, more preferably 2.0 or less, and even more preferably 1.5 or less.

An exemplary specific procedure for acquiring the shape (outer shape) and the average aspect ratio of the silica particles can be as follows: with use of a scanning electron microscope (SEM), collecting a predetermined number (e.g., 200) of the silica particles each independently having a discriminable shape; drawing a minimum rectangle circumscribed to an image of each of the collected particles; then calculating, as a major axis/minor axis ratio (aspect ratio), a value by dividing the long side length (major axis value) by the short side length (minor axis value) for the rectangle drawn for the image of each of the particles; and deriving the average aspect ratio from an arithmetic average of the aspect ratios for the predetermined number of the particles.

The polishing composition disclosed herein may contain an abrasive other than silica particles (hereinafter also referred to as "non-silica abrasive"), as far as an effect of the present invention is not significantly inhibited. Examples of the non-silica abrasive include inorganic particles, organic particles, and organic-inorganic composite particles. Specific examples of the inorganic particles include oxide particles such as alumina particles, cerium oxide particles, chromium oxide particles, titanium dioxide particles, zirconium oxide particles, magnesium oxide particles, manganese dioxide particles, zinc oxide particles, and red iron oxide particles; nitride particles such as silicon nitride particles and boron nitride particles; carbide particles such as silicon carbide particles and boron carbide particles; diamond particles; and carbonate salts such as calcium carbonate and barium carbonate. Specific examples of the organic particles include polymethylmethacrylate (PMMA) particles, poly(meth)acrylic acid particles ((meth)acrylic acid in this context is intended to refer inclusively to acrylic acid and methacrylic acid), and polyacrylonitrile particles. Such an abrasive can be used singly or in combination of two or more kinds thereof.

The art disclosed herein can be preferably performed in an embodiment where substantially only silica particles are used as the abrasive. In such a view, the proportion of silica particles in the total amount of the abrasive is suitably 90% by weight or more, preferably 95% by weight or more, and more preferably 98% by weight or more (e.g., 99 to 100% by weight).

The content of the abrasive (typically, silica particles) in the polishing composition is not particularly limited, and is, e.g., 0.01% by weight or more, preferably 0.05% by weight or more, more preferably 0.10% by weight or more, and even more preferably 0.15% by weight or more. Increase in the content of the abrasive can provide a higher polishing removal rate. The content is suitably 10% by weight or less, preferably 7% by weight or less, more preferably 5% by weight or less, and even more preferably 2% by weight or less, and may be, e.g., 1% by weight or less, 0.5% by weight or less, or 0.4% by weight or less. This allows providing a high-grade surface. The content of the abrasive described above may be preferably employed in an embodiment where the polishing composition is used in form of a polishing slurry (working slurry).

### <Basic Compound>

The polishing composition disclosed herein contains a basic compound. As used herein, a basic compound refers to a compound having a function to be dissolved in water to rise the pH of an aqueous solution. Inclusion of a basic compound in the polishing composition provides chemical polishing action (alkali etching), by which an object to be polished can be efficiently polished. Available examples of the basic compound include organic or inorganic nitrogen-containing basic compounds, phosphorus-containing basic compounds, hydroxides of alkali metals, hydroxides of alkaline earth metals, and various carbonate salts or hydrogen carbonate salts, but does not include the inorganic-acid ammonium salt described later. Examples of the nitrogen-containing basic compounds include quaternary ammonium compounds, ammonia, amines (preferably, water-soluble amines). Examples of the phosphorus-containing basic compounds include quaternary phosphonium compounds. Such a basic compound can be used singly or in combination of two or more kinds thereof.

Specific examples of the hydroxides of alkali metals include potassium hydroxide and sodium hydroxide. Specific examples of the carbonate salts or hydrogen carbonate salts include potassium hydrogen carbonate, potassium carbonate, sodium hydrogen carbonate, and sodium carbonate. Specific examples of the amines include, methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, triethylenetetramine, piperazine anhydride, piperazine hexahydrate, 1-(2-aminoethyl) piperazine, N-methylpiperazine, guanidine, and azoles such as imidazole and triazole. Specific examples of the quaternary phosphonium compounds include quaternary phosphonium hydroxides such as tetramethylphosphonium hydroxide and tetraethylphosphonium hydroxide.

As the quaternary ammonium compound, quaternary ammonium salts (typically, strong bases) such as tetraalkyl ammonium salts and hydroxyalkyl trialkyl ammonium salts can be used. An anion component in such quaternary ammonium salts may be, e.g., OH⁻, F⁻, Cl⁻, Br⁻, I⁻, ClO₄⁻, and BH₄⁻. Examples of the quaternary ammonium compound include quaternary ammonium salts having OH⁻ as an anion, i.e., quaternary ammonium hydroxides. Specific examples of the quaternary ammonium hydroxides include tetraalkyl ammonium hydroxides such as tetramethylammonium hydroxide, tetraethylammonium hydroxide, tetrapropylammonium hydroxide, tetrabutylammonium hydroxide, tetrapentylammonium hydroxide, and tetrahexylammonium hydroxide; hydroxyalkyl trialkylammonium hydroxides such as 2-hydroxyethyltrimethylammonium hydroxide (also referred to as choline).

Among these basic compounds, at least one kind of basic compound selected from e.g., alkali metal hydroxides, quaternary ammonium hydroxides, and ammonia can be preferably used. In particular, more preferred are tetraalkyl ammonium hydroxide (e.g., tetramethylammonium hydroxide) and ammonia, and particularly preferred is ammonia.

The content of a basic compound in the polishing composition is not particularly limited. In view of enhancing a polishing removal rate, usually, the content is suitably 0.0005% by weight or more, preferably 0.001% by weight or more, and more preferably 0.003% by weight or more. Moreover, in view of enhancing a surface quality (e.g., reducing haze) and the like, the content is suitably less than 0.1% by weight, preferably less than 0.05% by weight, and more preferably less than 0.03% by weight (e.g., less than 0.025% by weight, and furthermore, less than 0.01% by weight). Note that in combination use of two or more kinds of basic compounds, the content refers to the total content of two or more kinds of basic compounds. These contents can be preferably applied to, e.g., a content in a polishing slurry (working slurry) to be supplied to a substrate.

### <Inorganic-acid Ammonium Salt>

The polishing composition disclosed herein contains an inorganic-acid ammonium salt in addition to the silica abrasive and a basic compound. The inorganic-acid ammonium salt herein refers to a salt of inorganic acid as an anion and ammonium as a cation. Use of the inorganic-acid ammonium salt in composition containing the silica abrasive and a basic compound allows enhancing a polishing removal rate. More specifically, a polishing removal rate can be enhanced more significantly compared to composition containing no inorganic-acid ammonium salt or composition containing an organic acid ammonium salt. Action to enhance a polishing removal rate by the inorganic-acid ammonium salt can be effectively exserted even when presence of a water-soluble polymer, a surfactant, etc. provides protection of a surface to be polished; an embodiment including a water-soluble polymer, a surfactant, etc. thus allows enhancing a polishing removal rate along with maintaining a quality of a polishing surface (e.g., low haze value) produced by the water-soluble polymer and the like. The inorganic-acid ammonium salt can be used singly or in combination of two or more kinds thereof.

The valency of inorganic acid in the inorganic-acid ammonium salt is one or more, preferably two or more, and even more preferably three or more. More valencies in the inorganic acid lead to a tendency to facilitate achieving a better polishing removal rate. The number of ammonium cations in the inorganic-acid ammonium salt may correspond to the valency of the inorganic acid. Therefore, the number of ammonium cations per inorganic-acid ammonium salt molecule is one or more, preferably two or more, and even more preferably three or more.

Examples of inorganic acid in the inorganic-acid ammonium salt include hydrohalic acids (e.g., hydrochloric acid, hydrobromic acid, hydroiodic acid, and hydrofluoric acid), nitric acid, sulfuric acid, sulfurous acid, thiosulfuric acid, carbonic acid, silicic acid, boric acid, phosphoric acid, phosphonic acid, and phosphinic acid. In particular, the inorganic-acid ammonium salt is preferably a salt of nitric acid, sulfuric acid, carbonic acid, or phosphoric acid, and particularly preferably a salt of phosphoric acid (i.e., a phosphoric acid ammonium salt). Ammonium in the inorganic-acid ammonium salt may typically take a form of an inorganic ammonium cation (NH₄⁺).

Examples of the inorganic-acid ammonium salt include ammonium chloride, ammonium borate, ammonium fluoroborate, ammonium nitrate, ammonium sulfate, ammonium amidosulfate, ammonium persulfate, ammonium carbonate, ammonium hydrogen carbonate, ammonium dihydrogenphosphate, diammonium hydrogenphosphate, triammonium phosphate, ammonium phosphinate, and ammonium sulfide. In particular, preferred are ammonium nitrate, ammonium carbonate, ammonium hydrogen carbonate, ammonium sulfate, phosphoric acid ammonium salts (ammonium dihydrogenphosphate, diammonium hydrogenphosphate, triammonium phosphate, etc.), and more preferred are phosphoric acid ammonium salts. Among phosphoric acid ammonium salts, particularly preferred are ammonium dihydrogenphosphate and triammonium phosphate, and most preferred is triammonium phosphate.

The content of an inorganic-acid ammonium salt in the polishing composition is not particularly limited, and can be set so as to appropriately exert its effect of use. The content of the inorganic-acid ammonium salt can be, e.g., 0.0001% by weight or more, and in view of enhancing a polishing removal rate, it is suitably 0.0005% by weight or more, preferably 0.001% by weight or more, more preferably 0.003% by weight or more, and even more preferably 0.005% by weight or more, and may be 0.007% by weight or more, 0.010% by weight or more, 0.015% by weight or more, or 0.020% by weight or more. The content of the inorganic-acid ammonium salt may also be, e.g., 5% by weight or less, 1% by weight or less, or 0.3% by weight or less. In view of maintaining or enhancing a surface quality (e.g., maintaining haze and reducing haze) and the like, the content of the inorganic-acid ammonium salt is preferably 0.1% by weight or less, more preferably 0.05% by weight or less, and even more preferably 0.3% by weight or less, and may be 0.02% by weight or less, or 0.01% by weight or less (e.g., less than 0.01% by weight). These contents can be preferably applied to, e.g., a content in a polishing slurry (working slurry) supplied to an object to be polished.

Additionally, in an embodiment where the polishing composition contains the water-soluble polymer described later, the content of an inorganic-acid ammonium salt can be identified based on a relative relationship to the amount of the water-soluble polymer in the polishing composition (the total amount in presence of two or more kinds of water-soluble polymers). In particular, the ratio (C_{IAAS}/C_{WSP}) of the content of an inorganic-acid ammonium salt (C_{IAAS}) to the content of the water-soluble polymer (C_{WSP}) in the polishing composition is e.g., 0.01 or more on a weight basis, and in view of effectively exerting an effect to enhance a polishing removal rate by the inorganic-acid ammonium salt, the ratio is preferably 0.1 or more, and more preferably 0.3 or more, and may be 0.5 or more, 1 or more, 1.5 or more, or 2 or more. The ratio (C_{IAAS}/C_{WSP}) is also, e.g., 30 or less on a weight basis, preferably 10 or less, and more preferably 3 or less, and may be 1 or less, or 0.7 or less. Setting the amount of an inorganic-acid ammonium salt relative to the amount of the water-soluble polymer within the aforementioned range allows more effectively enhancing a polishing removal rate along with maintaining an effect to improve a surface quality (e.g., haze) by use of the water-soluble polymer.

Furthermore, in an embodiment where the polishing composition contains the surfactant described later, the content of an inorganic-acid ammonium salt can also be identified based on a relative relationship to the amount of a surfactant in the polishing composition (the total amount in presence of two or more kinds of surfactants). In particular, the ratio (C_{IAAS}/C_{S}) of the content of an inorganic-acid ammonium salt (C_{IAAS}) to the content of a surfactant (Cs) in the polishing composition is, e.g., 0.1 or more on a weight basis, and in view of effectively exerting an effect to enhance a polishing removal rate by the inorganic-acid ammonium salt, the ratio is preferably 1 or more, and more preferably 3 or more, and may be 5 or more, 10 or more, or 15 or more. The ratio (C_{IAAS}/C_{S}) is also, e.g., 100 or less on a weight basis, preferably 50 or less, and more preferably 30 or less, and may be 10 or less, or 7 or less. Setting the amount of an inorganic-acid ammonium salt relative to the amount of a surfactant within the aforementioned range allows more effectively enhancing a polishing removal rate along with maintaining an effect to improve a surface quality (e.g., haze) by use of the surfactant.

### <Water-soluble Polymer>

In some embodiments, the polishing composition preferably contains at least one kind of water-soluble polymer. A water-soluble polymer may serve protection of a substrate surface, enhancement in wettability of a polished substrate surface, etc. Inclusion of a water-soluble polymer in the polishing composition allows improving a polished surface quality (e.g., haze). According to the art disclosed herein, composition containing an inorganic-acid ammonium salt and a water-soluble polymer allows enhancing a polishing removal rate along with maintaining a quality of a polishing surface. In some embodiments, examples of the water-soluble polymer include compounds containing a hydroxyl group, a carboxy group, a acyloxy group, a sulfo group, an amide structure, an imido structure, a quaternary ammonium structure, a heterocyclic structure, a vinyl structure, etc. in a molecule. Available examples of the water-soluble polymer include cellulose derivatives, starch derivatives, oxyalkylene unit-containing polymers, polyvinyl alcohol-based polymers, and nitrogen atom-containing polymers. The water-soluble polymer may be a naturally-occurring polymer or a synthetic polymer. The water-soluble polymer can be used singly or in combination of two or more kinds thereof.

In some embodiments, a naturally-occurring polymer is used as the water-soluble polymer. Examples of the naturally-occurring polymer include cellulose derivatives and starch derivatives. The naturally-occurring polymer can be used singly or in combination of two or more kinds thereof.

In some embodiments, a cellulose derivative is used as the water-soluble polymer. As used herein, the cellulose derivative is a polymer that contains a β-glucose unit as a main repeating unit. Specific examples of the cellulose derivative include hydroxyethyl cellulose (HEC), hydroxypropyl cellulose, hydroxyethylmethyl cellulose, hydroxypropylmethyl cellulose, methylcellulose, ethylcellulose, ethylhydroxyethyl cellulose, and carboxy methylcellulose. The cellulose derivative can be used singly or in combination of two or more kinds thereof.

In some embodiments, a starch derivative is used as the water-soluble polymer. The starch derivative is a polymer containing an α-glucose unit as a main repeating unit, and examples thereof include pregelatinized starch, pullulan, carboxymethyl starch, and cyclodextrin. The starch derivative can be used singly or in combination of two or more kinds thereof.

In some preferred embodiments, a synthetic polymer is used as the water-soluble polymer. An effect by the art disclosed herein is preferably exerted in an embodiment where a synthetic polymer is used as the water-soluble polymer. The synthetic polymer can be used singly or in combination of two or more kinds thereof.

In some embodiments, an oxyalkylene unit-containing polymer is used as the water-soluble polymer. Examples of the oxyalkylene unit-containing polymer include polyethylene oxide (PEO), a block copolymer of ethylene oxide (EO) and propylene oxide (PO) or butylene oxide (BO), and a random copolymer of EO and PO or BO. In particular, preferred are a block copolymer of EO and PO or a random copolymer of EO and PO. The block copolymer of EO and PO may be a diblock copolymer or a triblock copolymer containing a PEO block and a polypropylene oxide (PPO) block, or the like. Examples of the triblock copolymer include PEO-PPO-PEO type triblock copolymers and PPO-PEO-PPO type triblock copolymers. Usually, more preferred are PEO-PPO-PEO type triblock copolymers.

A copolymer, as used herein, is intended to inclusively refer to various copolymers such as random copolymers, alternate copolymers, block copolymers, and graft copolymers, unless otherwise stated.

In a block copolymer or a random copolymer of EO and PO, the molar ratio (EO/PO) of EO and PO forming the copolymer is preferably more than 1, more preferably 2 or more, and even more preferably 3 or more (e.g., 5 or more) in view of solubility in water, cleanability, etc.

In some preferred embodiments, a polyvinyl alcohol-based polymer is used as the water-soluble polymer. Composition containing a polyvinyl alcohol-based polymer facilitates improving a polishing removal rate along with maintaining a polished surface quality. A polyvinyl alcohol-based polymer refers to a polymer containing a vinyl alcohol unit (hereinafter also referred to as "VA unit") as a repeating unit therein. The polyvinyl alcohol-based polymer can be used singly or in combination of two or more kinds thereof. The polyvinyl alcohol-based polymer may contain only VA units as repeating units, or a repeating unit other than VA units in addition to VA units (hereinafter also referred to as "non-VA unit). The polyvinyl alcohol-based polymer may be a random copolymer, a block copolymer, an alternate copolymer, a graft copolymer, or the like containing a VA unit and a non-VA unit. The polyvinyl alcohol-based polymer may contain only one kind of non-VA unit, or two or more kinds of non-VA units.

The polyvinyl alcohol-based polymer may be an unmodified polyvinyl alcohol (unmodified PVA) or a modified polyvinyl alcohol (modified PVA). An unmodified PVA, as used herein, refers to a polyvinyl alcohol-based polymer that is generated by hydrolyzing (saponifying) polyvinyl acetate and contains substantially no repeating unit other than repeating units having a structure derived by vinyl polymerization of vinyl acetate (-CH₂-CH(OCOCH₃)-) and VA units. The saponification degree of the unmodified PVA may be, e.g., 60% or more, and in view of water solubility, it may be 70% or more, 80% or more, or 90% or more.

The polyvinyl alcohol-based polymer may be a modified PVA containing a VA unit, and a non-VA unit having at least one structure selected from an oxyalkylene group, a carboxy group, a (di)carboxylic group, a (di)carboxylic ester group, a phenyl group, a naphthyl group, a sulfo group, an amino group, a hydroxy group, an amide group, an imide group, a nitrile group, an ether group, an ester group, and salts thereof. Examples of a non-VA unit that may be contained in the modified PVA may include, but are not limited to, a repeating unit derived from an *N*-vinyl-type monomer, an *N*-(meth)acryloyl-type monomer, or the like as described later, a repeating unit derived from ethylene, a repeating unit derived from alkyl vinyl ether, a repeating unit derived from a vinyl ester of monocarboxylic acid having a carbon atom number of 3 or more. A preferred example of the *N-*vinyl-type monomer may be *N*-vinylpyrrolidone. A preferred example of the *N*-(meth)acryloyl-type monomer can be *N-*(meth)acryloyl morpholine. The alkyl vinyl ether may be vinyl ether having an alkyl group having a carbon atom number of 1 or more to 10 or less, such as propylvinyl ether, butyl vinyl ether, or 2-ethylhexylvinyl ether. The vinyl ester of monocarboxylic acid having a carbon atom number of 3 or more may be a vinyl ester of monocarboxylic acid having a carbon atom number of 3 or more to 7 or less, such as vinyl propionate, vinyl butylate, vinyl pentanoate, and vinyl hexanoate.

Moreover, in some preferred embodiments, an acetalized polyvinyl alcohol-based polymer is used as the polyvinyl alcohol-based polymer. Examples of the acetalized polyvinyl alcohol-based polymer include a modified PVA where a part of VA units in the polyvinyl alcohol-based polymer are acetalized. A modified PVA (acetalized PVA (ac-PVA)) derived by acetalizing a part of VA units in the polyvinyl alcohol-based polymer can be provided by reacting and acetalizing a part of hydroxy groups in the polyvinyl alcohol-based polymer with an aldehyde compound or a ketone compound. Typically, the acetalized polyvinyl alcohol-based polymer can be provided by an acetalized reaction of the polyvinyl alcohol-based polymer and an aldehyde compound. In some preferred embodiments, the carbon number of the aldehyde compound is 1 to 7, and more preferably 2 to 7.

Examples of the aldehyde compound include formaldehyde; linear or branched alkyl aldehydes such as acetaldehyde, propionaldehyde, *n*-butylaldehyde, isobutylaldehyde, *t-*butylaldehyde, and hexylaldehyde; alicyclic or aromatic aldehydes such as cyclohexanecarbaldehyde, and benzaldehyde. These can be used singly or in combination of two or more kinds thereof. The aldehyde compound may also have one or more hydrogen atoms substituted with halogen or the like except for formaldehyde. In particular, in view of high solubility to water and ease of an acetalization reaction, preferred are linear or branched alkyl aldehydes, and particularly more preferred are acetaldehyde, *n*-propylaldehyde, *n*-butylaldehyde, and *n*-pentylaldehyde.

As the aldehyde compound, in addition to the aforementioned substances, an aldehyde compound having a carbon number of 8 or more, such as 2-ethylhexylaldehyde, nonyl aldehyde, or decyl aldehyde, may be used.

The acetalized polyvinyl alcohol-based polymer contains a VA unit of a structural segment represented by the following chemical formula: -CH₂-CH(OH)-, and an acetalized structure unit represented by the following general formula (1) (hereinafter also referred to as "VAC unit"). 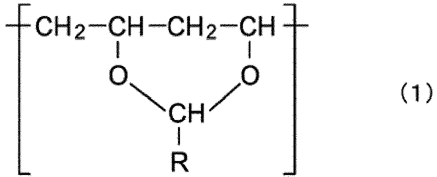 (in the formula (1), R is a hydrogen atom, or a linear or branched alkyl group, and the alkyl group may be substituted by a functional group.)

In some preferred embodiments, R in the formula (1) is a hydrogen atom or a linear or branched alkyl group having a carbon number of 1 to 6. Among these, R may be one kind or a combination of two or more kinds. In view of enhancing performance to reduce haze, R is preferably a linear or branched alkyl chain having a carbon number of 1 to 6.

In view of enhancing performance to reduce haze, the acetalization degree of the acetalized polyvinyl alcohol-based polymer can be 1% by mole or more, may be 5% by mole or more, preferably 10% by mole or more, more preferably 15% by mole or more, even more preferably 20% by mole or more, and particularly preferably 25% by mole or more (e.g., 27% by mole or more). In view of enhancing hydrophilicity, the acetalization degree of the acetalized polyvinyl alcohol-based polymer is preferably less than 60% by mole, further 50% by mole or less, more preferably 40% by mole or less, and particularly preferably 35% by mole or less (e.g., 33% by mole or less).

In addition, as a polyvinyl alcohol-based polymer, a cation-modified polyvinyl alcohol in which a cationic group such as a quaternary ammonium structure is introduced may be used. Examples of the cation-modified polyvinyl alcohol include a substance in which a cationic group derived from a monomer having a cationic group such as a diallyl dialkyl ammonium salt or an *N-*(meth)acryloyl aminoalkyl-*N,N,N*-trialkyl ammonium salt. The vinyl alcohol-based polymer may contain a non-VA unit having a structure segment represented by the chemical formula: -CH₂-CH(CR⁵(OR⁸)-CR⁶(OR⁹)-R⁷)-. Note that R⁵ to R⁷ each indicates independently a hydrogen atom or an organic group, R⁸ and R⁹ each indicates independently a hydrogen atom or R¹⁰-CO- (wherein R¹⁰ indicates an alkyl group). Examples of such a modified PVA include a modified PVA having a 1,2-diol structure on a side chain.

The proportion of the amount by mole of VA units in the amount by mole of all repeating units forming the polyvinyl alcohol-based polymer may be, e.g., 5% or more, 10% or more, 20% or more, or 30% or more. Without particular limitation, in some embodiments, the proportion of the amount by mole of the VA unit may be 50% or more, 65% or more, 75% or more, 80% or more, or 90% or more (e.g., 95% or more or 98% or more). Substantially 100% of repeating units forming the polyvinyl alcohol-based polymer may be VA units. As used herein, the phrase "substantially 100%" refers to not containing, at least intentionally, any non-VA unit in the polyvinyl alcohol-based polymer, and typically encompasses a case that the amount by mole of non-VA units is less than 2% (e.g., less than 1%) in the amount by mole of all repeating units and a case of 0%. In some other embodiments, the proportion of the amount by mole of VA units in all repeating units forming the polyvinyl alcohol-based polymer may be, e.g., 95% or less, 90% or less, 80% or less, or 70% or less.

The content (content on a weight basis) of VA units in the polyvinyl alcohol-based polymer may be, e.g., 5% by weight or more, 10% by weight or more, 20% by weight or more, or 30% by weight or more. Without particular limitation, in some embodiments, the content of the VA units may be 50% by weight or more (e.g., more than 50% by weight), 70% by weight or more, or 80% by weight or more (e.g., 90% by weight or more, or 95% by weight or more, or 98% by weight or more). Substantially 100% by weight of repeating units forming the polyvinyl alcohol-based polymer may be VA units. As used herein, the phrase "substantially 100% by weight" refers to not containing, at least intentionally, any non-VA unit forming the polyvinyl alcohol-based polymer as a repeating unit, and typically means that the content of non-VA units is less than 2% by weight (e.g., less than 1% by weight) in the polyvinyl alcohol-based polymer. In some other embodiments, the content of VA units in the polyvinyl alcohol-based polymer may be, e.g., 95% by weight or less, 90% by weight or less, 80% by weight or less, or 70% by weight or less.

The polyvinyl alcohol-based polymer may contain a plurality of polymer chains having various contents of VA units within the same molecule. As used herein, a polymer chain refers to a portion (segment) forming a part of a single molecule polymer. For example, the polyvinyl alcohol-based polymer may contain Polymer chain A, where the content of VA units is more than 50% by weight, and Polymer chain B, where the content of VA units is less than 50% by weight (i.e., the content of non-VA units is more than 50% by weight), within the same molecule.

Polymer chain A may contain only VA units as repeating units, or a non-VA unit in addition to VA units. The content of VA units in Polymer chain A may be 60% by weight or more, 70% by weight or more, 80% by weight or more, or 90% by weight or more. In some embodiments, the content of VA units in Polymer chain A may be 95% by weight or more, or 98% by weight or more. Substantially 100% by weight of repeating units forming Polymer chain A may be VA units.

Polymer chain B may contain only non-VA units as a repeating unit, or a VA unit in addition to non-VA units. The content of non-VA units in Polymer chain B may be 60% by weight or more, 70% by weight or more, 80% by weight or more, or 90% by weight or more. In some embodiments, the content of non-VA units in Polymer chain B may be 95% by weight or more, or 98% by weight or more. Substantially 100% by weight of repeating units forming Polymer chain B may be non-VA units.

Examples of a polyvinyl alcohol-based polymer containing Polymer chain A and Polymer chain B within the same molecule include a block copolymer, a graft copolymer, and the like containing these polymer chains. The graft copolymer may be a graft copolymer having a structure of Polymer chain A (main chain) grafted with Polymer chain B (side chain), or a graft copolymer having a structure of Polymer chain B (main chain) grafted with Polymer chain A (side chain). In an embodiment, a polyvinyl alcohol-based polymer having a structure of Polymer chain A grafted with Polymer chain B can be used.

Examples of Polymer chain B include a polymer chain containing a repeating unit derived from an *N*-vinyl-type monomer as a main repeating unit; a polymer chain containing a repeating unit derived from an *N*-(meth)acryloyl-type monomer as a main repeating unit; a polymer chain containing a repeating unit derived from dicarboxylic vinyl such as fumaric acid, maleic acid, maleic anhydride as a main repeating unit; a polymer chain containing a repeating unit derived from an aromatic vinyl monomer such as styrene and vinylnaphthalene as a main repeating unit; and a polymer chain containing an oxyalkylene unit as a main repeating unit. Note that a main repeating unit herein refers to a repeating unit occupying more than 50% by weight unless otherwise stated.

A preferred example of Polymer chain B is a polymer chain containing an *N*-vinyl-type monomer as a main repeating unit, i.e., an *N*-vinyl-based polymer chain. The content of repeating units derived from *N*-vinyl-type monomers in an *N*-vinyl-based polymer chain is typically more than 50% by weight, and may be 70% by weight or more, 85% by weight or more, or 95% by weight or more. Substantially all of Polymer chain B may be formed of repeating units derived from *N*-vinyl-type monomers.

Herein, examples of the *N*-vinyl-type monomer include a monomer having a nitrogen-containing heterocycle (e.g., lactam ring), and *N-*vinyl chain amide. Specific examples of the *N-*vinyl lactam-type monomer include *N*-vinylpyrrolidone, *N*-vinylpiperidone, *N*-vinylmorpholinone, *N*-vinylcaprolactam, *N*-vinyl-1,3-oxazine-2-one, and *N*-vinyl-3,5-morpholinedione. Specific examples of the *N*-vinyl chain amide include *N*-vinyl acetoamide, *N*-vinyl propionamide, and *N-*vinyl butyramide. Polymer chain B may be, e.g., an *N*-vinyl-based polymer chain containing *N-*vinylpyrrolidone units occupying more than 50% by weight (e.g., 70% by weight or more, or 85% by weight or more, or 95% by weight or more) of repeating units. Substantially all of repeating units forming Polymer chain B may be N-vinylpyrrolidone units.

Other examples of Polymer chain B include a polymer chain containing a repeating unit derived from an *N*-(meth)acryloyl-type monomer as a main repeating unit, i.e., an *N-*(meth)acryloyl-based polymer chain. The content of repeating units derived from *N*-(meth)acryloyl-type monomers in an *N*-(meth)acryloyl-based polymer chain is typically more than 50% by weight, and may be 70% by weight or more, 85% by weight or more, or 95% by weight or more. Substantially all of Polymer chain B may be formed of repeating units derived from *N*-(meth)acryloyl-type monomers.

Herein, examples of the *N*-(meth)acryloyl-type monomer include a chain amide having an *N-*(meth)acryloyl group, and a cyclic amide having an *N-*(meth)acryloyl group. Examples of the chain amide having an *N-*(meth)acryloyl group include (meth)acrylamide; *N*-alkyl (meth)acrylamides such as *N*-methyl (meth)acrylamide, *N*-ethyl (meth)acrylamide, *N*-propyl (meth)acrylamide, *N*-isopropyl (meth)acrylamide, and *N*-*n*-butyl (meth)acrylamide; and *N,N-*dialkyl (meth)acrylamide such as *N,N-*dimethyl (meth)acrylamide, *N,N-*diethyl (meth)acrylamide, *N,N-*dipropyl (meth)acrylamide, *N,N-*diisopropyl (meth)acrylamide, and *N,N-*di(*n*-butyl) (meth)acrylamide. Examples of the cyclic amide having an *N-*(meth)acryloyl group include *N-*(meth)acryloyl morpholine and *N-*(meth)acryloyl pyrrolidine.

Other examples of Polymer chain B include a polymer chain containing an oxyalkylene unit as a main repeating unit, i.e., an oxyalkylene-based polymer chain. The content of oxyalkylene units in the oxyalkylene-based polymer chain is typically more than 50% by weight, and may be 70% by weight or more, 85% by weight or more, or 95% by weight or more. Substantially all of repeating units in Polymer chain B may be oxyalkylene units.

Examples of the oxyalkylene unit include an oxyethylene unit, an oxypropylene unit, and an oxybutylene unit. Each of these oxyalkylene units may be a repeating unit derived from a corresponding alkylene oxide. Oxyalkylene units in the oxyalkylene-based polymer chain may consist of one kind or two or more kinds. For example, the oxyalkylene-based polymer chain may contain oxyethylene units and oxypropylene units in combination. In an oxyalkylene-based polymer chain containing two or more kinds of oxyalkylene units, each of these oxyalkylene units may be a random copolymer, a block copolymer, an alternate copolymer, a graft copolymer, or the like of a corresponding alkylene oxide.

Further examples of Polymer chain B include a polymer chain containing a repeating unit derived from alkyl vinyl ether (e.g., vinyl ether with an alkyl group having a carbon atom number of 1 or more to 10 or less), a polymer chain containing a repeating unit derived from monocarboxylic vinyl ester (e.g., vinyl ester of monocarboxylic acid having a carbon atom number of 3 or more), and a polymer chain introducing a cationic group (e.g., a cationic group having a quaternary ammonium structure).

A polyvinyl alcohol-based polymer as the water-soluble polymer in the art disclosed herein is preferably a modified polyvinyl alcohol that is a copolymer containing a VA unit and a non-VA unit. The saponification degree of the polyvinyl alcohol-based polymer as the water-soluble polymer is usually 50% by mole or more, preferably 65% by mole or more, more preferably 70% by mole or more, and e.g., 75% by mole or more. Note that the saponification degree of the polyvinyl alcohol-based polymer is theoretically 100% by mole or less.

In some preferred embodiments, a nitrogen atom-containing polymer is used as the water-soluble polymer. With a nitrogen atom-containing polymer, the polishing composition is likely to provide a high-quality polishing surface. Non-limited example of the nitrogen atom-containing polymer include a polymer containing an *N*-vinyl-type monomer unit; and a polymer containing an *N-*(meth)acryloyl-type monomer unit. The nitrogen atom-containing polymer can be used singly or in combination of two or more kinds thereof.

In some embodiments, an *N*-vinyl-type polymer may be used as the water-soluble polymer (nitrogen atom-containing polymer). Examples of the *N*-vinyl-type polymer include a polymer containing a repeating unit derived from a monomer having a nitrogen-containing heterocycle (e.g., lactam ring). Examples of such a polymer include homopolymers and copolymers of *N*-vinyllactam-type monomers (e.g., a copolymer containing *N*-vinyllactam-type monomers with a copolymerization ratio of more than 50% by weight), and homopolymers and copolymers of *N*-vinyl chain amide (e.g., a copolymer containing *N*-vinyl chain amide with a copolymerization ratio of more than 50% by weight).

Specific examples of the *N*-vinyllactam-type monomer (i.e., a compound having a lactam structure and a *N*-vinyl group within one molecule) include *N*-vinylpyrrolidone (VP), *N-*vinylpiperidone, *N*-vinylmorpholinone, *N*-vinylcaprolactam (VC), *N*-vinyl-1,3-oxazine-2-one, and *N*-vinyl-3,5-morpholinedione. Specific examples of a polymer containing the *N*-vinyllactam-type monomer unit include polyvinyl pyrrolidone; polyvinyl caprolactam; a random copolymer of VP and VC; a random copolymer of one or both of VP and VC with another vinyl monomer (e.g., an acrylic monomer and a vinyl ester-based monomer); and a block copolymer, an alternate copolymer, a graft copolymer, and the like containing a polymer chain containing one or both of VP and VC.

Specific examples of the *N*-vinyl chain amide include *N*-vinylacetoamide, *N*-vinyl-propionamide, and *N*-vinyl butyramide.

In some embodiments, an *N*-(meth)acryloyl-type polymer may be preferably used as the water-soluble polymer (a nitrogen atom-containing polymer). An effect from the art disclosed herein can be more preferably performed in composition containing an *N*-(meth)acryloyl-type polymer. Examples of the *N*-(meth)acryloyl-type polymer include homopolymers and copolymers of *N-*(meth)acryloyl-type monomers (typically, a copolymer containing *N*-(meth)acryloyl-type monomers with a copolymerization ratio of more than 50% by weight). Examples of the *N-*(meth)acryloyl-type monomer include a chain amide having an *N*-(meth)acryloyl group and a cyclic amide having an *N-*(meth)acryloyl group.

Examples of the chain amide having an *N-*(meth)acryloyl group include (meth)acrylamides; *N*-alkyl (meth)acrylamides such as *N*-methyl (meth)acrylamide, *N*-ethyl (meth)acrylamide, *N*-propyl (meth)acrylamide, *N*-isopropyl (meth)acrylamide, and *N-*n-butyl (meth)acrylamide; *N,N*-dialkyl (meth)acrylamides such as *N,N*-dimethyl (meth)acrylamide, *N,N-*diethyl (meth)acrylamide, *N,N-*dipropyl (meth)acrylamide, *N,N-*diisopropyl (meth)acrylamide, and *N,N*-di(*n*-butyl) (meth)acrylamide. Examples of a polymer containing the chain amide having an *N-*(meth)acryloyl group as a monomer unit include a homopolymer of *N*-isopropylacrylamide and a copolymer of *N*-isopropylacrylamide (e.g., a copolymer containing *N-*isopropylacrylamide with a copolymerization ratio of more than 50% by weight).

Examples of the cyclic amide having an *N-*(meth)acryloyl group include *N-*acryloylmorpholine, *N*-acryloylthiomorpholine, *N*-acryloylpiperidine, *N*-acryloylpyrrolidine, *N-*methacryloylmorpholine, *N-*methacryloylpiperidine, and *N*-methacryloylpyrrolidine. Examples of a polymer containing the cyclic amide having an *N-*(meth)acryloyl group as a monomer unit include an acryloyl morpholine-based polymer (PACMO). Typical examples of the acryloyl morpholine-based polymer include a homopolymer of *N*-acryloylmorpholine (ACMO) and a copolymer of ACMO (e.g., a copolymer containing ACMO with a copolymerization ratio of more than 50% by weight). In the acryloyl morpholine-based polymer, the proportion of the amount by mole of ACMO units in the amount by mole of all repeating units is usually 50% or more, and suitably 80% or more (e.g., 90% or more, typically 95% or more). All repeating units in the water-soluble polymer may be substantially occupied by ACMO units.

In some preferred embodiments, two or more kinds of water-soluble polymers are used. Selection and use of plural kinds of water-soluble polymers allows providing a good effect to improve haze. In such an embodiment, the polishing composition contains a first water-soluble polymer and a second water-soluble polymer other than the first water-soluble polymer as water-soluble polymers. In an embodiment where two or more kinds of water-soluble polymers are used, the types of the first water-soluble polymer and the second water-soluble polymer are not particularly limited, and each may employ any of the variety of the water-soluble polymers described above.

In some embodiments, as the first water-soluble polymer, a nitrogen atom-containing polymer (e.g., an *N*-(meth)acryloyl type polymer) can be used, while as the second water-soluble polymer, a water-soluble polymer other than nitrogen atom-containing polymers (e.g., *N-*(meth)acryloyl-type polymers) (a non-nitrogen atom-containing polymer such as non-*N-*(meth)acryloyl-type polymer) can be used. In some other embodiments, a polyvinyl alcohol-based polymer may be used as the second water-soluble polymer, and a water-soluble polymer other than polyvinyl alcohol-based polymers may be used as the first water-soluble polymer (a non-polyvinyl alcohol-based polymer). Combination use of the two or more kinds of water-soluble polymers enables balance of a surface quality and a polishing removal rate with higher levels. In some preferred embodiments, a nitrogen atom-containing polymer (e.g., an *N*-(meth)acryloyl-type polymer) is used as the first water-soluble polymer. Preferred is a polymer containing a cyclic amide having an N-(meth)acryloyl group as a monomer unit, and more preferred is PACMO. As the second water-soluble polymer, preferably used are e.g., a modified or unmodified polyvinyl alcohol-based polymer.

In an embodiment where two or more kinds of water-soluble polymers are used, the use ratio of the first water-soluble polymer (e.g., a nitrogen atom-containing polymer) and the second water-soluble polymer (e.g., a polyvinyl alcohol-based polymer) is not particularly limited. The ratio (C_{P1}/C_{P2}) of the content of the first water-soluble polymer (C_{P1}) to the content of the second water-soluble polymer (C_{P2}) is suitably 0.1 or more on a weight basis, and in view of effectively exerting an effect of use of the first water-soluble polymer, the ratio is preferably 0.5 or more, and more preferably 1 or more, and may be 2 or more (e.g., 3 or more). The ratio (C_{P1}/C_{P2}) is also suitably 20 or less on a weight basis, and in view of effectively exerting an effect of use of the second water-soluble polymer, the ratio is preferably 10 or less, and may be 5 or less. Setting the ratio (C_{P1}/C_{P2}) within the aforementioned range leads to a tendency to preferably exert actions of the first water-soluble polymer (e.g., a nitrogen atom-containing polymer) and the second water-soluble polymer (e.g., a polyvinyl alcohol-based polymer), thereby providing a high surface quality.

In the art disclosed herein, the weight average molecular weight (Mw) of the water-soluble polymer is not particularly limited. The Mw of the water-soluble polymer may be, e.g., approximately 200 × 10⁴ or less, and suitably approximately 150 × 10⁴ or less, and in view of cleanability and the like, the Mw is preferably approximately 100 × 10⁴ or less, and may be approximately 50 × 10⁴ or less. Additionally, in view of protectability of a polishing surface, the Mw of the water-soluble polymer may be, e.g., 0.2 × 10⁴ or more, and is preferably 0.5 × 10⁴ or more. In some embodiments, the Mw is suitably 1.0 × 10⁴ or more, may be 2 × 10⁴ or more, e.g., 5 × 10⁴ or more.

In the art disclosed herein, the preferred range of the molecular weight of the water-soluble polymer compound can be varied corresponding to the kind of a polymer to be used. For example, each Mw of the cellulose derivative and the starch derivative can be approximately 200 × 10⁴ or less, and is suitably 150 × 10⁴ or less. The Mw may be approximately 100 × 10⁴ or less, or approximately 50 × 10⁴ or less (e.g., approximately 30 × 10⁴ or less). Additionally, in view of protectability of a polishing surface, the Mw is, e.g., approximately 0.2 × 10⁴ or more, suitably approximately 0.5 × 10⁴ or more, preferably approximately 1.0 × 10⁴ or more, more preferably approximately 3.0 × 10⁴ or more, and even more preferably approximately 10 × 10⁴ or more, and may be approximately 20 × 10⁴ or more.

Moreover, for example, the Mw of the polyvinyl alcohol-based polymer can be 100 × 10⁴ or less, and suitably 60 × 10⁴ or less. In view of concentration efficiency and the like, the Mw may be 30 × 10⁴ or less, preferably 20 × 10⁴ or less, e.g., 10 × 10⁴ or less, 8 × 10⁴ or less, 5 × 10⁴ or less, or 3 × 10⁴ or less. When the polyvinyl alcohol-based polymer has a smaller Mw, the polyvinyl alcohol-based polymer tends to have improved dispersion stability. Additionally, in view of preferably protecting a polishing surface and maintaining or improving a surface quality, the Mw may be e.g., 0.2 × 10⁴ or more, and is usually preferably 0.5 × 10⁴ or more. Increase in the Mw of the polyvinyl alcohol-based polymer leads to a tendency to provide higher effects to protect an object to be polished and increase wettability. In such a view, the Mw in some embodiments is suitably 0.8 × 10⁴ or more, and preferably 1.0 × 10⁴ or more, and may be 2 × 10⁴ ormore, 3 × 10⁴ or more, e.g., 4 × 10⁴ or more, and 5 × 10⁴ or more.

Furthermore, for example, the Mw of the nitrogen atom-containing polymer (e.g., an *N-*(meth)acryloyl-type polymer, preferably PACMO) can be 100 × 10⁴ or less, and is suitably 70 × 10⁴ or less. In view of concentration efficiency and the like, the Mw may be 60 × 10⁴ or less, or 50 × 10⁴ or less. Additionally, in view of maintaining or improving a surface quality, the Mw may be e.g., 1.0 × 10⁴ or more, or 10 × 10⁴ or more. In some embodiments, the Mw is suitably 20 × 10⁴ or more, and preferably 30 × 10⁴ or more, and may be, e.g., 40 × 10⁴ or more.

As the Mw of the water-soluble polymer, a molecular weight calculated from a value based on aqueous gel permeation chromatography (GPC) (aqueous phase, on polyethylene oxide conversion basis) can be employed. As a GPC measurement apparatus, the machine named "HLC-8320GPC" manufactured by Tosoh Corporation can be used. Measurement conditions can be as follows. Measurement can be performed in accordance with, e.g., the following conditions. The same method is also employed to the examples described later.

### [GPC Measurement Conditions]

Sample concentration: 0.1% by weight
Column: TSKgel GMPWXL
Detector: differential refractometer
Elution liquid: 100 mM sodium nitrate aqueous solution/acetonitrile = 10 to 8/0 to 2
Flow rate: 1 mL/min
Measurement temperature: 40°C
Sample injection volume: 200 µL

In view of reducing aggregation, enhancing cleanability, etc., a nonionic polymer can be preferably employed as the water-soluble polymer. In view of ease of control of a chemical structure, purity, etc., a synthetic polymer can be preferably employed as the water-soluble polymer. For example, when the art disclosed herein is performed in an embodiment including a synthetic polymer as the water-soluble polymer, the polishing composition may have substantially no use of naturally-occurring polymer as the water-soluble polymer. Note that substantially no use means that the usage of a naturally-occurring polymer relative to 100 parts by weight of the total content of the water-soluble polymer is typically 3 parts by weight or less, and preferably 1 part by weight or less, and encompasses 0 parts by weight or a detection limit or less.

When the polishing composition disclosed herein contains the water-soluble polymer, the content of the water-soluble polymer in the polishing composition (the total amount in presence of two or more kinds of water-soluble polymers) is not particularly limited. For example, it can be 0.0001% by weight or more. In view of reducing haze, etc., the content is preferably 0.0005% by weight or more, more preferably 0.001% by weight or more, even more preferably 0.002% by weight or more, and e.g., 0.005% by weight or more. In view of a polishing removal rate and the like, the content is also preferably 0.2% by weight or less, more preferably 0.1% by weight or less, and even more preferably 0.05% by weight or less (e.g., 0.02% by weight or less, and further, 0.015% by weight or less). These contents can be applied to, e.g., a content in a polishing slurry (working slurry) supplied to a substrate. Alternatively, in view of providing more simple composition, etc., the polishing composition disclosed herein can be provided even in an embodiment containing substantially no water-soluble polymer.

In an embodiment where the polyvinyl alcohol-based polymer is used as the water-soluble polymer, the content of the polyvinyl alcohol-based polymer in the polishing composition (the total amount in presence of two or more kinds of polyvinyl alcohol-based polymers) is not particularly limited. In view of enhancing a surface quality, the content in some embodiments may be, e.g., 0.0001% by weight or more, usually suitably 0.0005% by weight or more, and preferably 0.001% by weight or more, and may be, e.g., 0.002% by weight or more. The upper limit of the content of the polyvinyl alcohol-based polymer is not particularly limited, and can be, e.g., 0.05% by weight or less. In view of stability in a concentrated liquid form, a polishing removal rate, cleanability, etc., the content of the polyvinyl alcohol-based polymer in some embodiments is preferably 0.03% by weight or less, more preferably 0.015% by weight or less, and even more preferably 0.01% by weight or less. The polishing composition disclosed herein can be preferably provided even in an embodiment e.g., where the content of the polyvinyl alcohol-based polymer is 0.008% by weight or less, 0.006% by weight or less, or 0.004% by weight or less. These contents may be preferably applied to, e.g., a content in a polishing slurry (working slurry) supplied to a substrate.

In an embodiment where a nitrogen atom-containing polymer is used as the water-soluble polymer, the content of the nitrogen atom-containing polymer in the polishing composition (the total amount in presence of two or more kinds of nitrogen atom-containing polymers) is not particularly limited. In view of enhancing a surface quality, the content in some embodiments may be, e.g., 0.0001% by weight or more, usually suitably 0.0005% by weight or more, preferably 0.001% by weight or more, more preferably 0.002% by weight or more, and even more preferably 0.003% by weight or more, and may be 0.005% by weight or more. The upper limit of the content of the nitrogen atom-containing polymer is not particularly limited, and can be, e.g., 0.1% by weight or less. In view of stability in a concentrated liquid form, a polishing removal rate, cleanability, etc., the content of a nitrogen atom-containing polymer in some embodiments is preferably 0.05% by weight or less, more preferably 0.02% by weight or less, and even more preferably 0.01% by weight or less. These contents may be preferably applied to, e.g., a content in a polishing slurry (working slurry) supplied to a substrate.

The content of the water-soluble polymer (the total amount in presence of two or more kinds of water-soluble polymers) can also be identified based on a relative relationship to the abrasive (typically, silica particles). Without particular limitation, the content of the water-soluble polymer relative to 100 parts by weight of the abrasive in some embodiments can be e.g., 0.01 parts by weight or more, and in view of reducing haze, the content is suitably 0.1 parts by weight or more, preferably 0.5 parts by weight or more, more preferably 1 part by weight or more, and even more preferably 3 parts by weight or more, and may be, e.g., 4 parts by weight or more. The content of the water-soluble polymer relative to 100 parts by weight of the abrasive may also be, e.g., 50 parts by weight or less, or 30 parts by weight or less. In view of dispersion stability of the polishing composition, etc., the content of the water-soluble polymer relative to 100 parts by weight of the abrasive in some embodiments is suitably 15 parts by weight or less, and preferably 10 parts by weight or less, and may be 8 parts by weight or less, or 7 parts by weight or less.

In an embodiment where a polyvinyl alcohol-based polymer is used as the water-soluble polymer, the content of the polyvinyl alcohol-based polymer in the polishing composition (the total amount in presence of two or more kinds of polyvinyl alcohol-based polymers) can also be identified based on a relative relationship to the abrasive (typically, silica particles). Without particular limitation, the content of the polyvinyl alcohol-based polymer relative to 100 parts by weight of the abrasive in some embodiments can be, e.g., 0.01 parts by weight or more, and in view of reducing haze, the content is suitably 0.1 parts by weight or more, preferably 0.5 parts by weight or more, and more preferably 1 part by weight or more. The content of the polyvinyl alcohol-based polymer relative to 100 parts by weight of the abrasive may also be e.g., 50 parts by weight or less, or 30 parts by weight or less. In view of dispersion stability of the polishing composition, the content of the polyvinyl alcohol-based polymer relative to 100 parts by weight of the abrasive in some embodiments is suitably 15 parts by weight or less, preferably 10 parts by weight or less, and more preferably 5 parts by weight or less, and may be 3 parts by weight or less.

In an embodiment where a nitrogen atom-containing polymer is used as the water-soluble polymer, the content of the nitrogen atom-containing polymer (the total amount in presence of two or more kinds of nitrogen atom-containing polymers) in the polishing composition can also be identified based on a relative relationship to the abrasive (typically, silica particles). Without particular limitation, the content of the nitrogen atom-containing polymer relative to 100 parts by weight of the abrasive in some embodiments can be, e.g., 0.01 parts by weight or more, and in view of reducing haze and the like, the content is suitably 0.1 parts by weight or more, preferably 0.5 parts by weight or more, more preferably 1 part by weight or more, and even more preferably 3 parts by weight or more. The content of the nitrogen atom-containing polymer relative to 100 parts by weight of the abrasive may also be, e.g., 50 parts by weight or less, or 30 parts by weight or less. In view of dispersion stability of the polishing composition, etc., the content of the nitrogen atom-containing polymer relative to 100 parts by weight of the abrasive in some embodiments is suitably 15 parts by weight or less, and preferably 10 parts by weight or less, and may be, e.g., 5 parts by weight or less.

### <Surfactant>

In some embodiments, the polishing composition preferably contains at least one kind of surfactant. Inclusion of a surfactant in the polishing composition can better reduce haze on a polished surface of an object to be polished. According to the art disclosed herein, composition containing an inorganic-acid ammonium salt and a surfactant enables enhancing a polishing removal rate along with maintaining a quality (particularly, haze) of a polishing surface. As the surfactant, any of anionic, cationic, nonionic, or amphoteric substance is available. Usually, an anionic or nonionic surfactant can be preferably employed. In view of low foamability, ease of pH adjustment, etc., a nonionic surfactant is more preferable. Examples of the nonionic surfactant include oxyalkylene polymers such as polyethylene glycol, polypropylene glycol, and polytetramethylene glycol; polyoxyalkylene derivatives (e.g., polyoxyalkylene adducts) such as polyoxyethylene alkyl ether, polyoxyethylene alkyl phenylether, polyoxyethylene alkyl amine, polyoxyethylene fatty acid ester, polyoxyethylene glycerylether fatty acid ester, and polyoxyethylene sorbitan fatty acid ester; and copolymers of plural kinds of oxyalkylene (e.g., diblock type copolymers, triblock type copolymers, random type copolymers, and alternate copolymers). The surfactant can be used singly or in combination of two or more kinds thereof.

Specific examples of the nonionic surfactant include block copolymers of ethylene oxide (EO) and propylene oxide (PO) (diblock type copolymers, PEO (polyethylene oxide)-PPO (polypropylene oxide)-PEO type triblock copolymers, PPO-PEO-PPO type triblock copolymers, etc.), random copolymers of EO and PO, polyoxyethylene glycol, polyoxyethylene propylether, polyoxyethylene butylether, polyoxyethylene pentylether, polyoxyethylene hexylether, polyoxyethylene octylether, polyoxyethylene-2-ethylhexylether, polyoxyethylene nonylether, polyoxyethylene decylether, polyoxyethylene isodecylether, polyoxyethylene tridecylether, polyoxyethylene laurylether, polyoxyethylene cetylether, polyoxyethylene stearylether, polyoxyethylene isostearylether, polyoxyethylene oleylether, polyoxyethylene phenylether, polyoxyethylene octylphenylether, polyoxyethylene nonylphenylether, polyoxyethylene dodecylphenylether, polyoxyethylene styrated phenylether, polyoxyethylene laurylamine, polyoxyethylene stearylamine, polyoxyethylene oleylamine, polyoxyethylene monolaurate, polyoxyethylene monostearate, polyoxyethylene distearate, polyoxyethylene monooleate, polyoxyethylene dioleate, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbit tetraoleate, polyoxyethylene castor oil, and polyoxyethylene castor wax. Particularly preferred examples of the surfactant include block copolymers of EO and PO (in particular, PEO-PPO-PEO type triblock copolymers), random copolymers of EO and PO, and polyoxyethylene alkyl ether (e.g., polyoxyethylene decylether). As such polyoxyethylene alkyl ether, a substance in which the number of EO moles added is about 1 to 10 (e.g., about 3 to 8) can be preferably employed.

In some preferred embodiments, two or more kinds of surfactants are used. Selection and use of plural kinds of surfactants allows providing a good effect to improve haze. All of the two or more kinds of surfactants are preferably nonionic surfactants. In such an embodiment, the polishing composition contains a first surfactant and a second surfactant other than the first surfactant as surfactants. The types of the first surfactant and the second surfactant are not particularly limited, and each may employ any of a variety of the surfactants as described above. In some embodiments, polyoxyethylene alkyl ether may be used as the first surfactant, and a block copolymer of EO and PO (e.g., PEO-PPO-PEO type triblock copolymer) may be used as the second surfactant. Combination use of the two or more kinds of surfactants allows balance of a surface quality and a polishing removal rate with higher level.

In an embodiment where two or more kinds of surfactants are used, the use ratio of the first surfactant (e.g., polyoxyethylene alkyl ether) to the second surfactant (e.g., a block copolymer of EO and PO) is not particularly limited. The ratio (C_{S1}/C_{S2}) of the content of the first surfactant (C_{S1}) to the content of the second surfactant (C_{S2}) is suitably 0.1 or more on a weight basis, and in view of effectively exerting an effect of use of the first surfactant, the ratio is preferably 0.3 or more, more preferably 0.5 or more, and even more preferably 1 or more (e.g., more than 1). The ratio (C_{S1}/C_{S2}) is suitably 20 or less on a weight basis, and in view of effectively exerting an effect of use of the second surfactant, the ratio is preferably 10 or less, and more preferably 5 or less, and may be 3 or less. Setting the ratio (C_{S1}/C_{S2}) within the aforementioned range leads to a tendency to preferably exert actions of the first surfactant (e.g., polyoxyethylene alkyl ether) and the second surfactant (e.g., a block copolymer of EO and PO), thereby providing a high surface quality.

The molecular weight of the surfactant is, e.g., less than 1 × 10⁴, and in view of filterability, cleanability, etc., the molecular weight is preferably 9500 or less, and may be, e.g., less than 9000. In view of interfacial action or the like, the molecular weight of the surfactant is also usually suitably 200 or more, and in view of an effect to reduce haze or the like, the molecular weight is preferably 250 or more (e.g., 300 or more). The more preferred range of the molecular weight of the surfactant may also be varied corresponding to the type of the surfactant. For example, when polyoxyethylene alkyl ether is used as a surfactant, the molecular weight is preferably e.g., less than 2000, more preferably 1900 or less (e.g., less than 1800), and even more preferably 1500 or less, and may be 1000 or less (e.g., 500 or less). In addition, for example, when a block copolymer of EO and PO is used as a surfactant, the weight average molecular weight thereof may be, e.g., 500 or more, 1000 or more, and further 1500 or more, 2000 or more, and further 2500 or more. The upper limit of the weight average molecular weight, e.g., less than 1 × 10⁴, and preferably 9500 or less, and may be, e.g., less than 9000, less than 7000, or less than 5000.

As the molecular weight of the surfactant, a molecular weight calculated from a chemical formula may be employed, or a value of a weight average molecular weight derived by GPC (aqueous phase, on polyethylene glycol conversion basis) may be employed. For example, polyoxyethylene alkyl ether preferably employs a molecular weight calculated from a chemical formula, and a block copolymer of EO and PO preferably employs a weight average molecular weight derived by the GPC as described above.

When the polishing composition disclosed herein contains a surfactant, the content of the surfactant in the polishing composition (the total amount in presence of two or more kinds of surfactants) is not particularly limited, as far as an effect of the present invention is not significantly impaired. Usually, in view of cleanability and the like, the content of the surfactant can be e.g., 0.00001% by weight or more. In view of reducing haze, etc., the content is preferably 0.0001% by weight or more, more preferably 0.0005% by weight or more, and even more preferably 0.001% by weight or more. In view of a polishing removal rate, etc., the content is also preferably 0.1% by weight or less, more preferably 0.01% by weight or less, and even more preferably 0.005% by weight or less (e.g., 0.002% by weight or less, and further, 0.0015% by weight or less). These contents can be preferably applied to, e.g., a content in a polishing slurry (working slurry) supplied to a substrate. Alternatively, in view of providing more simple composition, etc., the polishing composition disclosed herein can also be performed in an embodiment including substantially no surfactant.

The content of the surfactant (the total amount in presence of two or more kinds of surfactants) can also be identified based on a relative relationship to the abrasive (typically, silica particles). Usually, in view of cleanability and the like, the content of the surfactant relative to 100 parts by weight of the abrasive (typically, silica particles) is suitably 20 parts by weight or less, preferably 10 parts by weight or less, and more preferably 6 parts by weight or less (e.g., 3 parts by weight or less). In view of better exerting an effect of use of the surfactant, the content of the surfactant relative to 100 parts by weight of the abrasive is suitably 0.001 parts by weight or more, preferably 0.01 parts by weight or more, and more preferably 0.1 parts by weight or more, and may be 0.5 parts by weight or more.

The polishing composition disclosed herein can be preferably provided in an embodiment including at least one kind of water-soluble polymer and at least one kind of surfactant. Combination use of a water-soluble polymer and a surfactant can achieve a better effect to reduce haze. According to the art disclosed herein, use of an inorganic-acid ammonium salt in composition containing a water-soluble polymer and a surfactant as described above enables enhancing a polishing removal rate along with maintaining a good effect to reduce haze. In such an embodiment, the proportion of the content of the water-soluble polymer (the total amount in presence of two or more kinds) to the content of the surfactant (the total amount in presence of two or more kinds) is not particularly limited. The ratio (C_{WSP}/C_{S}) of the content of the water-soluble polymer (C_{WSP}) to the content of the surfactant (C_{S}) is e.g., 0.01 or more, and suitably 0.05 or more on a weight basis. In view of effectively exerting an effect of use of the water-soluble polymer, the ratio (C_{WSP}/C_{S}) is preferably 0.1 or more (e.g., more than 0.1), more preferably 0.5 or more, and even more preferably 1 or more (e.g., more than 1), and may be 3 or more, or 5 or more. The ratio (C_{WSP}/C_{S}) is also e.g., 200 or less, suitably 100 or less on a weight basis. In view of effectively exerting an effect of use of a surfactant, the ratio (C_{WSP}/C_{S}) is preferably 70 or less, more preferably 50 or less, and even more preferably 30 or less, and may be 15 or less, or 10 or less. Setting of the ratio (C_{WSP}/C_{S}) within the aforementioned range leads to a tendency to preferably exert an effect of combination use of a water-soluble polymer and a surfactant, thereby providing a high surface quality.

### <Water>

Examples of water in the polishing composition disclosed herein to be potentially preferably used include ion-exchanged water (deionized water), pure water, ultrapure water, and distilled water. In water to be used, the content of transition metal ions is preferably, e.g., 100 ppb or less in total, in order to avoid inhibiting a function of another component in the polishing composition as much as possible. For example, water can have improved purity by removal of impurity ions by ion-exchange resin, removal of contaminants by a filter, distillation, etc. The polishing composition disclosed herein may further contain an organic solvent that can be uniformly mixed with water (lower alcohol, lower ketone, etc.), as appropriate. In a solvent(s) in the polishing composition, water preferably accounts for 90% by volume or more, and more preferably 95% by volume or more (e.g., 99 to 100% by volume).

### <Other components>

The polishing composition disclosed herein may further contain, as appropriate, a known additive that can be used for a polishing composition (e.g., a polishing composition used for a final polishing step of a silicon wafer), such as organic acid, an organic acid salt, inorganic acid, an inorganic acid salt, a chelator, an antiseptic agent, or an antifungal agent, as far as an effect of the present invention is not significantly inhibited.

The organic acid and salts thereof, and inorganic acid and salts thereof can be used singly or in combination of two or more kinds thereof. Examples of the organic acid include aliphatic acids such as formic acid, acetic acid, and propionic acid; aromatic carboxylic acids such as benzoic acid and phthalic acid; itaconic acid; citric acid; oxalic acid; tartaric acid; malic acid; maleic acid; fumaric acid; succinic acid; glycolic acid; malonic acid; gluconic acid; alanine; glycine; lactic acid; hydroxyethylidene diphosphoric acid (HEDP); organic sulfonic acid such as methanesulfonic acid; nitrilotris (methylenephosphoric acid) (NTMP); and organic phosphonic acid such as phosphonobutane tricarboxylic acid (PBTC). Examples of the organic acid salt include alkali metal salts (sodium salts, potassium salts, etc.) and ammonium salts of organic acid. Examples of the inorganic acid include hydrochloric acid, phosphoric acid, sulfuric acid, phosphonic acid, nitric acid, phosphinic acid, boric acid, and carbonic acid. Examples of the inorganic acid salt include alkali metal salts (sodium salts, potassium salts, etc.) of inorganic acid.

The chelator can be used singly or in combination of two or more kinds thereof. Examples of the chelator include aminocarboxylic acid-based chelators and organic phosphonic acid-based chelators. Preferred examples of the chelators include ethylenediamine tetrakis(methylenephosphinic acid), diethylene triamine penta(methylenephosphinic acid), and diethylene triamine pentaacetic acid. Examples of the antiseptic agent and antifungal agent include isothiazoline-based compounds, paraoxybenzoic acid esters, and phenoxyethanol.

The polishing composition disclosed herein preferably contains substantially no oxidant. This is because when the polishing composition contains an oxidant, supply of the polishing composition to a substrate (e.g., a silicon wafer) can cause oxidation on a surface of the substrate and generate an oxide layer, thereby reducing a polishing removal rate. Specific examples of an oxidant in this context include hydrogen peroxide (HzOz), sodium persulfate, ammonium persulfate, and sodium dichroloisocyanurate. The phrase that the polishing composition contains substantially no oxidant means not containing an oxidant at least intentionally. Accordingly, when inevitably containing a small amount of an oxidant (e.g., the molar concentration of an oxidant in the polishing composition is 0.0005 mole/L or less, preferably 0.0001 mole/L or less, more preferably 0.00005 mole/L or less, and particularly preferably 0.00001 mole/L or less) derived from a raw material, a product method, etc., the polishing composition can be encompassed within the concept of a polishing composition containing substantially no oxidant in this context.

### <pH>

The pH of the polishing composition disclosed herein is not particularly limited, and suitable pH can be employed corresponding to a substrate, etc. In some embodiments, the pH of the polishing composition is appropriately 8.0 or more, preferably 8.5 or more, and more preferably 9.0 or more. Higher pH of the polishing composition tends to lead to increase in a polishing removal rate. Meanwhile, in view of preventing dissolution of the abrasive (particularly, silica particles) and suppressing reduction in action of mechanical polishing, the pH of the polishing composition is usually, suitably 12.0 or less, preferably 11.0 or less, more preferably 10.8 or less, and even more preferably 10.5 or less.

In the art disclosed herein, the pH of the polishing composition can be known by performing three-point calibration with standard buffers (a phthalate pH buffer with pH 4.01 (25°C), a neutral phosphate pH buffer with pH 6.86 (25°C), and a carbonate pH buffer with pH 10.01 (25°C)) using a pH meter (e.g., a glass-electrode hydrogen ion concentration indicator (model: F-72) manufactured by Horiba, Ltd.), and then inserting a glass electrode into a composition to be measured, leaving it to stand for 2 minutes or more until stabilization and conducting measurement.

### <Electric Conductivity>

The electric conductivity of the polishing composition is not particularly limited. In some embodiments, in view of enhancing a polishing removal rate, the electric conductivity may be, e.g., 0.01 mS/cm or more, 0.03 mS/cm or more, 0.05 mS/cm or more, or 0.10 mS/cm or more. In view of dispersion stability of the polishing composition, etc., the electric conductivity may be, e.g., 1 mS/cm or less, 0.70 mS/cm or less, or 0.50 mS/cm or less. In such an embodiment with relatively low electric conductivity, it is preferred to use two or more kinds of water-soluble polymers, thereby facilitating providing an effect to reduce haze. In some embodiments, the electric conductivity may be 0.4 mS/cm or less, less than 0.3 mS/cm, less than 0.25 mS/cm, less than 0.20 mS/cm, less than 0.18 mS/cm, or less than 0.15 mS/cm. According to the art disclosed herein, with electric conductivity of a predetermined value or less as described above, the polishing composition enables enhancement in a polishing removal rate. In other words, reduction in haze and enhancement in a polishing removal rate can be preferably combined.

Measurement of electric conductivity can be performed under a condition at a liquid temperature of 25°C in a common method. As a measurement device, the electric conductivity meter of model "DS-12" manufactured by Horiba Ltd. can be exemplarily used. In the examples described later, the electric conductivity meter was used to measure electric conductivity.

### <Polishing Slurry>

The polishing composition disclosed herein is typically supplied onto a surface of a substrate in form of a polishing slurry containing the polishing composition, and used for polishing the substrate. The polishing slurry can be, e.g., prepared by diluting any of the polishing compositions disclosed herein (typically, diluting with water). Alternatively, the polishing composition may be used directly as a polishing slurry. In other words, the concept of the polishing composition in the art disclosed herein encompasses both of a polishing slurry (working slurry) supplied to a substrate to be used for polishing of the substrate, and a concentrate (a stock solution of a polishing slurry) diluted to be used as a polishing slurry. Other examples of the polishing slurry containing the polishing composition disclosed herein include a polishing slurry formed by adjusting the pH of the composition.

### <Concentrate>

The polishing composition disclosed herein may be a concentrated form (i.e., a concentrate form of a polishing slurry) before supply to a substrate. Such a concentrated form of the polishing composition is advantageous in view of convenience, cost reduction, etc. in production, distribution, storage, etc. The concentration factor is not particularly limited, can be, e.g., about 2-fold to 100-fold in volume, and is usually suitably about 5-fold to 50-fold (e.g., about 10-fold to 40-fold).

Such a concentrate can be diluted at a desired timing to prepare a polishing slurry (a working slurry), and can be used in an embodiment of supplying the polishing slurry to a substrate. The dilution can be performed, e.g., by adding water to the concentrate and mixing them.

In an embodiment where the polishing composition contains an abrasive, when the polishing composition (i.e., a concentrate) is diluted and used for polishing, the content of the abrasive in the concentrate can be, e.g., 25% by weight or less. In view of dispersion stability, filterability, etc. of the polishing composition, the content is usually, preferably 20% by weight or less, and more preferably 15% by weight or less. In a preferred embodiment, the content of the abrasive may be 10% by weight or less, or 5% by weight or less. In view of convenience and cost reduction, etc. in production, distribution, storage, etc., the content of the abrasive in the concentrate can be, e.g., 0.1% by weight or more, and is preferably 0.5% by weight or more, more preferably 0.7% by weight or more, and even more preferably 1% by weight or more.

### <Preparation of Polishing Composition>

The polishing composition in the art disclosed herein may be a single-agent type or a multi-agent type such as a two-agent type. For example, the composition may be configured to prepare a polishing slurry by mixing of Part A, which contains at least an abrasive among components of the polishing composition, and Part B, which contains at least a part of the remaining components, and mixing and diluting them at an appropriate timing, as appropriate.

A preparation method of the polishing composition is not particularly limited. For example, a well-known mixing apparatus such as a blade stirrer, an ultrasonic disperser, or a homomixer can be used to mix each component included in the polishing composition. An embodiment of mixing these components is not particularly limited, and for example, all components may be mixed at a time or may be mixed in an order set appropriately.

### <Application>

The polishing composition disclosed herein can be applied to polishing of substrates with various material qualities and shapes. Examples of materials of the substrates include metals or semimetals such as silicon, aluminum, nickel, tungsten, copper, tantalum, titanium, and stainless steel, or alloys thereof; glassy substances such as quartz glass, aluminosilicate glass, and glassy carbon; ceramic materials such as alumina, silica, sapphire, silicon nitride, tantalum nitride, and titanium carbide; compound semiconductor substrate materials such as silicon carbide, gallium nitride, and gallium arsenide; and resin materials such as polyimide resins. In particular, the substrate may be formed of a plurality of materials. The shape of a substrate is not particularly limited. The polishing composition disclosed herein can be applied to polishing of a substrate having a plane that has, e.g., a plate shape or a polyhedron shape, or polishing of an end of a substrate (e.g., polishing of a wafer edge).

The polishing composition disclosed herein can be particularly preferably used for polishing of a surface formed of a silicon material (typically, polishing of a silicon wafer). A typical example of the silicon wafer in this context is a silicon single crystal wafer, such as a silicon single crystal wafer derived by slicing a silicon single crystal ingot.

The polishing composition disclosed herein can be preferably applied to a polishing step of a substrate (e.g., a silicon wafer). The substrate may be subjected to common treatment that can be applied to a substrate in a step upstream of a polishing step, such as lapping or etching, before a polishing step with the polishing composition disclosed herein.

The polishing composition disclosed herein is effective for use in a final step or an immediately preceding polishing step of a substrate (e.g., a silicon wafer), and use in a final polishing step is particularly preferred. The final polishing step in this context refers to a last polishing step (i.e., a step preceding no further polishing) in a production process of an object. The polishing composition disclosed herein may also be used for a polishing step at the upstream relative to a final polishing (that refers to a stock polishing step between a rough polishing step and a last polishing step, typically includes at least a primary polishing step, and may further include a secondary, tertiary or more-order polishing step(s)), e.g., a polishing step performed just before final polishing.

The polishing composition disclosed herein is effective in application to polishing (typically, final polishing or the preceding polishing thereof) of e.g., a silicon wafer prepared to have a surface with a surface roughness of 0.01 nm to 100 nm through an upstream step. Application to final polishing is particularly preferred. The surface roughness Ra of a substrate can be measured using e.g., the laser scanning surface roughness meter "TMS-3000WRC" manufactured by Schmitt Measurement System Inc.

### <Polishing>

The polishing composition disclosed herein can be used for polishing of a substrate e.g., in an embodiment including the following operation. Description will now be made for a preferred embodiment of a method of polishing a silicon wafer as a substrate with use of the polishing composition disclosed herein.

In other words, a polishing slurry containing any of the polishing compositions disclosed herein is provided. Provision of the polishing slurry may contain subjecting the polishing composition to operation such as concentration adjustment (e.g., dilution), pH adjustment, etc., thereby preparing the polishing slurry. Alternatively, the polishing composition may be directly used as a polishing slurry.

Then, the polishing slurry is supplied to a substrate, and polishing is carried out by a common method. For example, in final polishing of a silicon wafer, typically, a silicon wafer that experienced a lapping step is set in a typical polishing machine, and then the polishing slurry is supplied via a polishing pad of the polishing machine onto a surface to be polished in the silicon wafer. Typically, while the polishing slurry is consecutively supplied, a polishing pad is pushed against a surface to be polished of a silicon wafer and both are relatively moved (e.g., rotatably moved). Through such a polishing step, polishing of a substrate is completed.

A polishing pad used in the polishing step is not particularly limited. For example, polishing pads such as a foamed polyurethane type, a non-woven fabric type, and a suede type can be used. Each polishing pad may or may not contain an abrasive. Usually, a polishing pad containing no abrasive is preferably used.

A substrate polished using the polishing composition disclosed herein is typically cleaned. Cleaning can be performed using a suitable cleaning liquid. A cleaning liquid to be used herein is not particularly limited. For example, SC-1 cleaning liquid (a mixture solution of ammonium hydroxide (NH₄OH), hydrogen peroxide (H₂O₂), and water (H₂O)), SC-2 cleaning liquid (a mixture solution ofHCl, H₂O₂, and H₂O), etc., which are common in the art of semiconductors or the like, can be used. For example, temperature of a cleaning liquid can be within the range of room temperature (typically, about 15°C to 25°C) or higher to about 90°C. In view of improving an effect of cleaning, a cleaning liquid at 50°C to 85°C can be preferably used.

As mentioned above, the art disclosed herein may include providing a method of producing a polished material including a polishing step (preferably, final polishing) by any of the aforementioned polishing methods (e.g., a method of producing a silicon wafer) and a polished material (e.g., a silicon wafer) produced by the method.

### [Examples]

Several examples relating to the present invention will be described below, but the present invention is not intended to be limited to the embodiments shown in the examples. In the following description, "part" and "%" are on a weight basis unless otherwise specified.

### <Preparation of Polishing Composition>

### (Examples 1 to 8)

A polishing composition according to each of the examples was prepared by mixing an abrasive, a basic compound, an inorganic-acid ammonium salt, a water-soluble polymer, a surfactant, and deionized water. As the abrasive, colloidal silica (average primary particle diameter: 25 nm) was used. As the basic compound, ammonia was used. As the inorganic-acid ammonium salt, the types shown in Table 1 were used. As the water-soluble polymer, polyacryloyl morpholine (PACMO) with a Mw of about 4.7 × 10⁵ and acetalized polyvinyl alcohol (ac-PVA) with a Mw of about 1.0 × 10⁴ were used. As the surfactant, polyoxyethylene (ethyleneoxide moles added: 5) decyl ether (C10EO5)) with a molecular weight of 378 and a PEO-PPO-PEO block copolymer (PEO-PPO-PEO) with a Mw of 3000 were used. A concentrate of the polishing composition thus obtained was diluted 20-fold on a volume ratio basis with deionized water, thereby providing a polishing composition according to each of the examples containing the following concentrations of components: 0.17% the abrasive, 0.005% the basic compound, the inorganic-acid ammonium salt with the concentration shown in Table 1, 0.008% PACMO, 0.0025% ac-PVE1, 0.0008% C10EO5, and 0.0004% PEO-PPO-PEO.

### (Comparative Example 1)

A polishing composition according to this example was prepared in the same manner as in Example 1 except for adding no inorganic-acid ammonium salt.

### (Comparative Example 2)

A polishing composition according to this example was prepared in the same manner as in Example 1 except for using an organic acid ammonium salt (triammonium citrate) instead of an inorganic-acid ammonium salt.

### <Polishing of Silicon Wafer>

As a substrate, a silicon wafer was prepared by lapping and etching a commercially available silicon single crystal wafer (conduction type: P type; crystal orientation: <100>; COP (crystal originated particle: crystal fault) free) with a diameter of 300 mm that was then subjected to stock polishing under Polishing condition 1 as follows. The stock polishing was performed using a polishing slurry containing 1.0% abrasive (colloidal silica with an average primary particle diameter of 35 nm) and 0.068% potassium hydroxide in deionized water.

### [Polishing Condition 1]

Polishing machine: a sheet-fed polishing machine manufactured by Okamoto Machine Tool Works, Ltd., model "PNX-332B"
Polishing load: 20 kPa
Rotation speed of platen: 20 rpm
Rotation speed of head (carrier): 20 rpm
Polishing pad: manufactured by Nitta Dupont Incorporated, product name "SUBA400"
Supply rate of polishing slurry: 1 L/min
Temperature of polishing slurry: 20°C
Temperature of platen cooling water: 20°C
Polishing time: 3 mins

Using the polishing composition according to each of the examples prepared as described above as a polishing slurry, the silicon wafer after stock polishing was polished under Polishing condition 2 as follows.

### [Polishing Condition 2]

Polishing machine: a sheet-fed polishing machine manufactured by Okamoto Machine Tool Works, Ltd., model "PNX-332B"
Polishing load: 10 kPa
Rotation speed of platen: 50 rpm
Rotation speed of head (carrier): 50 rpm
Polishing pad: manufactured by Fujibo Ehime Co., Ltd., product name "POLYPAS275NX"
Supply rate of polishing slurry: 1.5 L/min
Temperature of polishing slurry: 20°C
Temperature of platen cooling water: 20°C
Polishing time: 4 mins

The polished silicon wafer was removed from the polishing machine, and cleaned with a cleaning liquid having NH₄OH (29%) : H₂O₂ (31%) : deionized water (DIW) = 2:5.3:48 (volume ratio) (SC-1 cleaning). More particularly, a first cleaning tank equipped with an ultrasonicator was provided, then the cleaning liquid was charged in the first cleaning tank and kept at 60°C, and the polished silicon wafer was immersed in the cleaning tank for 6 minutes. Subsequently, the silicon wafer was immersed in a second cleaning tank containing ultrapure water at 25°C for 8 minutes, then immersed again in the first cleaning tank for 6 minutes, and in the second cleaning tank for 16 minutes, and dried.

### <Measurement of Haze>

A surface of the cleaned silicon wafer was measured for haze (ppm) at DW2O mode using a wafer testing apparatus having the product name of "Surfscan SP5" and manufactured by KLA-Tencor Corporation (present KLA Corporation). The result thus obtained was converted to a relative value to a haze value in Comparative Example 1 as 100%. A smaller value of haze indicates having a higher effect to improve haze.

### <Polishing Removal Rate>

A silicon wafer (conduction type: P type; crystal orientation: <100>; COP free) with a diameter of 200 mm was prepared as an object to be polished, immersed in an aqueous HF solution (HF concentration: 2%) for 60 seconds to remove an oxide layer, and polished under Polishing condition 3 as follows using a polishing composition according to each of the examples as a polishing slurry.

### [Polishing Condition 3]

Polishing machine: a sheet-fed polishing machine manufactured by Okamoto Machine Tool Works, Ltd., model "PNX-322"
Polishing load: 10 kPa
Rotation speed of platen: 30 rpm
Rotation speed of head (carrier): 30 rpm
Polishing pad: manufactured by Fujibo Ehime Co., Ltd., product name "POLYPAS275NX"
Supply rate of polishing slurry: 400 mL/min
Temperature of polishing slurry: 20°C
Temperature of platen cooling water: 20°C
Polishing time: 10 mins

The polished silicon wafer was removed from the polishing machine, immersed in a cleaning liquid with NH₄OH (29%) : H₂O₂ (31%) : deionized water = 1:1:12 (volume ratio) for 5 minutes, and cleaned (SC-1 cleaning). Then, the wafer was immersed in deionized water with an ultrasonicater running, and dried with a spin drier.

### (Evaluation)

The weight of the silicon wafer after and before polishing was measured to calculate a polishing removal rate[nm/min] from their difference in weight and the specific gravity of silicon. The results thus obtained was converted into a relative value based on the polishing removal rate in Comparative Example 1 as 100%. A larger value indicates a higher polishing removal rate. A polishing removal rate more than 120% is evaluated to indicate enhancement in a polishing removal rate.

Table 1 shows a summary and evaluation results of each of the examples. Table 1 also presents electric conductivities of polishing compositions. In the table, "-" indicates non-containing.

### [Table 1]

**Table 1**

| | Abrasive | Basic compound | Ammonium salt | | Electric co nd uctivity [mS/cm] | Haze [%] | Polishing removal rate [%] |
|---|---|---|---|---|---|---|---|
| | | | Type | Content [%] | | | |
| Example 1 | colloidal silica | ammonia | ammonium nitrate | 0.008 | 0.18 | 101 | 124 |
| Example 2 | | | ammonium nitrate | 0.025 | 0.49 | 101 | 132 |
| Example 3 | | | ammonium hydrogen carbonate | 0.024 | 0.37 | 102 | 137 |
| Example 4 | | | ammonium carbonate | 0.015 | 0.32 | 104 | 136 |
| Example 5 | | | ammonium sulfate | 0.020 | 0.44 | 103 | 133 |
| Example 6 | | | ammonium dihydrogenphosphate | 0.012 | 0.32 | 101 | 203 |
| Example 7 | | | diammonium hydrogenphosphate | 0.021 | 0.44 | 99 | 246 |
| Example 8 | | | triammonium phosphate | 0.005 | 0.13 | 98 | 307 |
| Comparative Example 1 | | | - | - | 0.06 | 100 | 100 |
| Comparative Example 2 | | | triammonium citrate | 0.008 | 0.43 | 101 | 111 |

As shown in Table 1, Examples 1 to 8, each employing a polishing composition containing silica abrasive, a basic compound, and an inorganic-acid ammonium salt, provided polishing removal rates increased by more than 120% along with keeping haze within the range of 98 to 104%, compared to Comparative Example 1, employing a polishing composition containing no inorganic-acid ammonium salt. In particular, Examples 6 to 8, each employing a phosphoric acid ammonium salt, enabled achieving a better polishing removal rate. Meanwhile, Comparative Example 2, employing an ammonium salt of organic acid, exhibited an effect to improve a polishing removal rate (111%), which is nevertheless less than an effect from use of an inorganic-acid ammonium salt.

The results demonstrates that additional inclusion of an inorganic-acid ammonium salt in composition containing silica particles as an abrasive, a basic compound, and water allows production of a composition suitable for polishing.

While specific examples of the present invention have been described above in detail, these are only illustrative, and do not limit the scope of the claims. The technologies recited in the claims include various modifications and alternations of the specific examples illustrated above.

## Claims

1. A polishing composition comprising silica particles as an abrasive, a basic compound, and water, and
further comprising an inorganic-acid ammonium salt.

2. The polishing composition according to claim 1, wherein the inorganic-acid ammonium salt comprises divalent or more polyvalent inorganic acid.

3. The polishing composition according to claim 1 or 2, wherein the inorganic-acid ammonium salt comprises a phosphoric acid ammonium salt.

4. The polishing composition according to any one of claims 1 to 3, further comprising at least one kind of water-soluble polymer.

5. The polishing composition according to claim 4, wherein the water-soluble polymer comprises two or more kinds of water-soluble polymer.

6. The polishing composition according to claim 4 or 5, wherein the water-soluble polymer comprises a polyvinyl alcohol-based polymer.

7. The polishing composition according to any one of claims 4 to 6, wherein the water-soluble polymer comprises a nitrogen atom-containing polymer.

8. The polishing composition according to any one of claims 1 to 7, further comprising at least one kind of surfactant.

9. The polishing composition according to claim 8, wherein the surfactant comprises two or more kinds of nonionic surfactants.

10. The polishing composition according to any one of claims 1 to 9, used for polishing of a silicon wafer.

11. A concentrate of the polishing composition according to any one of claims 1 to 10.
